# EUROPÄISCHE PATENTANMELDUNG

(11) **EP 3 744 555 A1**
(43) Veröffentlichungstag der Anmeldung: **02.12.2020**
(21) Anmeldenummer: 20175396.9
(22) Anmeldetag: 19.05.2020
(51) Int. Cl.: B60L 3/00, B60L 3/04, B60L 15/00, H05K 5/02, H05K 7/14

(54) **ANTRIEBSEINRICHTUNG FÜR EIN ELEKTRISCH ANTREIBBARES FAHRZEUG UND FAHRZEUG**

(30) Priorität: 29.05.2019 DE 102019114523
(71) Anmelder: Valeo Siemens eAutomotive Germany GmbH, 91056 Erlangen (DE)
(72) Erfinder: GRUSSMANN, Ondrej, 25225 Zbuzany (CZ); FRANK, Alexander, 97688 Bad Kissingen (DE)
(74) Vertreter: Dr. Gassner & Partner mbB

(57) **Zusammenfassung**

Antriebseinrichtung (1) für ein elektrisch antreibbares Fahrzeug (35), umfassend
- einen Gehäusekörper (5) mit einem ersten Befestigungsmittel (9),
- eine Abdeckung (11), die nach Lösen eines mit dem ersten Befestigungsmittel (9) zum Befestigen der Abdeckung (11) am Gehäusekörper (5) wechselwirkenden zweiten Befestigungsmittels (10) aus einer ersten Stellung, in der die Abdeckung (11) im Betrieb der Antriebseinrichtung (1) spannungsführende Komponenten (12) der Antriebseinrichtung (1) abdeckt, in eine zweite Stellung, in welcher die Komponenten (12) freiliegen, bewegbar ist, und
- ein erstes Verbindungsmittel (13), an das ein zweites Verbindungsmittel (14) zur Herstellung einer elektrisch leitfähigen Verbindung und/oder einer Datenverbindung anschließbar ist,
wobei das erste Befestigungsmittel (9) und das erste Verbindungsmittel (13) so angeordnet sind, dass in der ersten Stellung ein Zugriff auf das zweite Befestigungsmittel (10) in seiner die Abdeckung (11) befestigenden Position erst nach einem Lösen des zweiten Verbindungsmittels (14) vom ersten Verbindungsmittel (13) möglich ist.

## Beschreibung

Die vorliegende Erfindung betrifft eine Antriebseinrichtung für ein elektrisch antreibbares Fahrzeug, umfassend einen Gehäusekörper mit einem ersten Befestigungsmittel, eine Abdeckung, die nach Lösen eines mit dem ersten Befestigungsmittel zum Befestigen der Abdeckung am Gehäusekörper wechselwirkenden zweiten Befestigungsmittels aus einer ersten Stellung, in der die Abdeckung im Betrieb der Antriebseinrichtung spannungsführende Komponenten der Antriebseinrichtung abdeckt, in eine zweite Stellung, in welcher die Komponenten freiliegen, bewegbar ist, und ein erstes Verbindungsmittel, an das ein zweites Verbindungsmittel zur Herstellung einer elektrisch leitfähigen Verbindung und/oder einer Datenverbindung anschließbar ist.

Daneben betrifft die Erfindung ein Fahrzeug.

Antriebseinrichtungen für elektrisch antreibbare Fahrzeuge weisen typischerweise bewegbare Abdeckungen auf, um zwischen der Abdeckung und einem durch sie abgedeckten Gehäusekörper angeordnete Komponenten warten zu können. Wenn diese Komponenten im Betrieb der Antriebseinrichtung eine Spannung von mehr als 60 Volt führen, sind in der Regel Sicherheitsmaßnahmen vorgesehen, um ein unbeabsichtigtes oder unzulässiges Berühren der Komponenten im spannungsführenden Zustand zu vermeiden.

Das Dokument DE 20 2015 006 792 U1 offenbar ein Elektrofahrzeug mit einer elektrischen Baugruppe, die eine Sicherheitsvorrichtung zum Schutz vor gefährlichen Berührspannungen an einem elektrischen Bauteil in der elektrischen Baugruppe aufweist. Die Sicherheitsvorrichtung umfasst einen Servicedeckel an einem Baugruppengehäuse der elektrischen Baugruppe, welcher für einen Normalbetrieb der elektrischen Baugruppe eine Service-Öffnung zu einem Gehäuseinnenraum verschließt. Der Servicedeckel ist durch mindestens ein Servicedeckel-Befestigungsmittel mit dem Baugruppengehäuse verbunden. Ferner weist die Sicherheitsvorrichtung eine Sicherheitsanformung des Servicedeckels mit einer Aussparung und eine von der Sicherheitsanformung ausgebildete Umfassung der Aussparung auf. Für den Normalbetrieb ist eine mit dem Baugruppengehäuse mechanisch verbundene Signalsteckerverbindung durch die Aussparung führbar, wobei die Umfassung zwischen einer Signalbuchse und einem mit der Signalbuchse verbundenen Signalstecker der Signalsteckerverbindung anordenbar ist. Für einen Service ist der Signalstecker von der Signalbuchse trennbar, wobei die Umfassung von der Signalsteckerverbindung sowie der Servicedeckel vom Baugruppengehäuse entfernbar sind.

Nachteilig an einer solchen Antriebseinrichtung ist, dass nach einem Entfernen des dem zweiten Verbindungsmittel entsprechenden Signalsteckers ein unmittelbares Entfernen der Abdeckung vom Gehäusekörper möglich ist, wenn die Befestigung der Abdeckung am Gehäusekörper bereits gelöst ist. Denn die Abdeckung wird dann nur noch durch das zweite Verbindungsmittel in seiner ersten Stellung gehalten wird. Die Abdeckung kann mithin so schnell entfernt werden, dass eine Sicherheitseinrichtung, die ein Lösen des zweiten Verbindungsmittels überwacht, die spannungsführenden Komponenten nicht rechtzeitig vor der Entfernung der Abdeckung in einen sicheren Zustand überführen kann.

Der Erfindung liegt mithin die Aufgabe zugrunde, eine verbesserte Möglichkeit zum Schutz spannungsführender Komponenten in einer Antriebseinrichtung vor unerwünschten Berührungen anzugeben, insbesondere eine Entfernung einer die spannungsführende Komponenten abdeckenden Abdeckung zu erschweren.

Diese Aufgabe wird erfindungsgemäß bei einer Antriebseinrichtung der eingangs genannten Art dadurch gelöst, dass das erste Befestigungsmittel und das erste Verbindungsmittel so angeordnet sind, dass in der ersten Stellung ein Zugriff auf das zweite Befestigungsmittel in seiner die Abdeckung befestigenden Position erst nach einem Lösen des zweiten Verbindungsmittels vom ersten Verbindungsmittel möglich ist.

Die Erfindung beruht auf der Überlegung, das Lösen der durch das erste und zweite Befestigungsmittel realisierten Befestigung der Abdeckung am Gehäusekörper erst nach dem Lösen des zweiten Verbindungsmittels vom ersten Verbindungsmittel zu ermöglichen, um so einen zusätzlichen Zeitaufwand und ein zusätzliches Erschwernis für das Überführen der Abdeckung aus der ersten Stellung in die zweite Stellung zu schaffen. Dadurch wird vorteilhafterweise ein Zugriff auf die spannungsführenden Komponenten der Antriebseinrichtung effektiv erschwert und so die Gefahr einer unbeabsichtigten oder unzulässigen Berührung, beispielsweise im Wartungs- oder Reparaturfall, verhindert.

Die erfindungsgemäße Antriebseinrichtung kann ferner das zweite Befestigungsmittel und/oder das zweite Verbindungsmittel umfassen. Daneben kann der Gehäusekörper ein oder mehrere dritte Befestigungsmittel aufweisen, die jeweils zum Befestigen der Abdeckung am Gehäuse mit einem vierten Befestigungsmittel wechselwirken können. Ein Zugriff auf das jeweilige vierte Befestigungsmittel, das insbesondere auch Teil der Antriebseinrichtung ist, kann jedoch unabhängig vom Verbindungszustand des ersten und zweiten Verbindungsmittels möglich sein.

Es wird bei der erfindungsgemäßen Antriebseinrichtung bevorzugt, wenn das erste Verbindungsmittel eine Führung für das zweite Verbindungsmittel aufweist, deren gedachte Verlängerung das erste Befestigungsmittel überdeckt. Die Führung stellt mithin sicher, dass das zweite Verbindungsmittel entlang einer Richtung mit dem ersten Verbindungsmittel verbunden wird, bei der das zweite Verbindungsmittel das erste Befestigungsmittel bzw. das mit ihm wechselwirkende zweite Befestigungsmittel überdeckt.

Es kann insbesondere vorgesehen sein, dass das erste Befestigungsmittel und das erste Verbindungsmittel jeweils an einem Abschnitt des Gehäusekörpers angeordnet sind, wobei die Abschnitte winklig, insbesondere rechtwinklig, zueinander verlaufen.

Zweckmäßigerweise ist vorgesehen, dass das erste Verbindungsmittel ein, insbesondere als Buchse ausgebildeter, Steckverbinder ist und/oder das zweite Verbindungsmittel ein, insbesondere als Stecker ausgebildeter, Steckverbinder ist und/oder das erste Befestigungsmittel ein Loch mit einem Innengewinde ist und/oder das zweite Befestigungsmittel eine Schraube ist.

Die erfindungsgemäße Antriebseinrichtung umfasst bevorzugt ferner eine Sicherheitseinrichtung, welche zum Erfassen wenigstens eines kritischen Zustands der Antriebseinrichtung und zum Auslösen einer Sicherheitsfunktion infolge der Erfassung des kritischen Zustands eingerichtet ist. Durch die Sicherheitseinrichtung wird vorteilhafterweise ein mehrstufiges Sicherheitskonzept der Antriebseinrichtung realisiert, die den Berührschutz noch weiter erhöht.

Dabei wird es besonders bevorzugt, wenn die Sicherheitseinrichtung dazu eingerichtet ist, den kritischen Zustand zu erfassen, wenn die Verbindungsmittel nicht miteinander gekoppelt sind. Dies ist von besonderem Vorteil, da so beim Lösen der Verbindungsmittel voneinander die Sicherheitsfunktion ausgelöst werden kann. Da erst nach diesem Lösen der Zugriff auf das zweite Befestigungsmittel eröffnet ist und zusätzlicher Zeitaufwand für dessen Lösen vom ersten Befestigungsmittel erforderlich ist, besteht so ausreichend Zeit für die Durchführung der Sicherheitsfunktion. Es kann vorgesehen sein, dass das erste Verbindungsmittel einen Kontakt aufweist, der durch das Entfernen des zweiten Verbindungsmittels trennbar ist, wobei der kritische Zustand anhand der Trennung erfassbar ist.

Alternativ oder zusätzlich kann die Sicherheitseinrichtung dazu eingerichtet sein, den einen kritischen Zustand zu erfassen, wenn sich die Abdeckung nicht in der ersten Stellung befindet. Dazu kann die Sicherheitseinrichtung insbesondere ein am Gehäusekörper angeordnetes drittes Verbindungsmittel und ein an der Abdeckung angeordnet des viertes Verbindungsmittel umfassen, welche derart angeordnet sind, dass sie in der ersten Stellung der Abdeckung eine Verbindung miteinander eingehen, welche beim Überführen der Abdeckung aus der ersten Stellung in die zweite Stellung trennbar ist, wobei der kritische Zustand anhand der Trennung erfassbar ist.

Ferner kann vorgesehen sein, dass die Sicherheitseinrichtung dazu eingerichtet ist, den einen kritischen Zustand zu erfassen, wenn kein zweites Befestigungsmittel mit dem ersten Befestigungsmittel wechselwirkt. So kann insbesondere verhindert werden, dass die Komponenten bestromt werden, wenn die Abdeckung zurück in die erste Stellung gebracht wird, das erste und das zweite Verbindungsmittel miteinander gekoppelt werden und das zweite Befestigungsmittel nicht zur Befestigung mit dem ersten Befestigungsmittel wechselwirkt, sodass bei einem folgenden Versuch des Überführens der Abdeckung aus der ersten Stellung in die zweite Stellung die gewünschte zeitliche Verzögerung entfallen würde.

Die Sicherheitseinrichtung kann ferner eine Stromschleife und eine Auswerteeinheit aufweisen, die dazu eingerichtet ist, den kritischen Zustand anhand einer Trennung der Stromschleife zu erfassen. Insofern kann die Sicherheitseinrichtung auch als Interlocksystem aufgefasst werden.

Die erfindungsgemäß realisierte zeitliche Verzögerung ist besonders vorteilhaft, wenn die Sicherheitsfunktion ein Entladen eines Kondensators der Antriebseinrichtung umfasst. Dazu kann Sicherheitseinrichtung eine Entladeeinheit zum Entladen des Kondensators aufweisen. Die Entladeeinheit kann insbesondere als aktive Entladeeinheit ausgebildet sein.

Mit Vorteil kann bei der erfindungsgemäßen Antriebseinrichtung vorgesehen sein, dass die Abdeckung einen Abdeckungsabschnitt zum Abdecken eines die Komponenten aufnehmenden Volumens des Gehäusekörpers und einen vom Abdeckungsabschnitt abstehenden Befestigungsabschnitt aufweist, auf weichen das erste und zweite Befestigungsmittel zum Befestigen der Abdeckung wirken. Der Befestigungsabschnitt kann insbesondere laschenartig ausgebildet sein. Bevorzugt weist Befestigungsabschnitt einen ersten Teilabschnitt auf, der winklig vom Abdeckungsabschnitt abstellt. Der Befestigungsabschnitt kann einen zweiten Teilabschnitt aufweisen, der winklig vom ersten Teilabschnitt absteht. Bevorzugt weist der Befestigungsabschnitt eine Durchgangsöffnung auf, durch welche das zweite Befestigungsmittel durchführbar ist. Besonders bevorzugt ist die Durchgangsöffnung im zweiten Teilabschnitt ausgebildet.

Gemäß einer bevorzugten Ausgestaltung der erfindungsgemäßen Antriebseinrichtung ist vorgesehen, dass der Gehäusekörper und die Abdeckung ein Scharnier ausbilden, mittels dessen die Abdeckung durch Schwenken aus der ersten Stellung in die zweite Stellung bewegbar ist. Eine solche verschwenkbare Anordnung der Abdeckung am Gehäusekörper kann gerade dadurch ermöglicht werden, dass das erste Verbindungsmittel die Abdeckung nicht durchsetzen muss, wie es beispielsweise im Dokument DE 20 2015 006 792 U1 vorgesehen ist.

Die erfindungsgemäße Antriebseinrichtung umfasst vorteilhafterweise ferner eine elektrische Maschine und einen Stromrichter, wobei die von der Abdeckung abdeckbaren Komponenten elektrische Leitungen umfassen, welche die elektrische Maschine und den Stromrichter verbinden. Die Abdeckung und der von der Abdeckung abgedeckte Teil des Gehäusekörpers können insofern als Anschlussbox oder Terminalbox aufgefasst werden. Typischerweise ist der zuvor erwähnte Kondensator ein Zwischenkreiskondensator des Stromrichters.

Die der Erfindung zugrunde liegende Aufgabe wird ferner gelöst durch ein Fahrzeug, umfassend eine erfindungsgemäße Antriebseinrichtung. Das Fahrzeug ist beispielsweise ein Elektrofahrzeug oder ein Hybridfahrzeug.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: eine Draufsicht auf ein erstes Ausführungsbeispiel der erfindungsgemäßen Antriebseinrichtung;
- Fig. 2 und 3: jeweils eine Detailansicht der in Fig. 1 gezeigten Antriebseinrichtung;
- Fig. 4: eine perspektivische Ansicht der in Fig. 1 gezeigten Antriebseinrichtung beim Überführen einer Abdeckung aus einer ersten Stellung in eine zweite Stellung;
- Fig. 5: ein Blockschaltbild der in Fig. 1 gezeigten Antriebseinrichtung;
- Fig. 6 und 7: jeweils eine perspektivische Ansicht einer Abdeckung eines weiteren Ausführungsbeispiels der erfindungsgemäßen Antriebseinrichtung; und
- Fig. 8: eine Prinzipskizze eines Ausführungsbeispiels des erfindungsgemäßen Fahrzeugs.

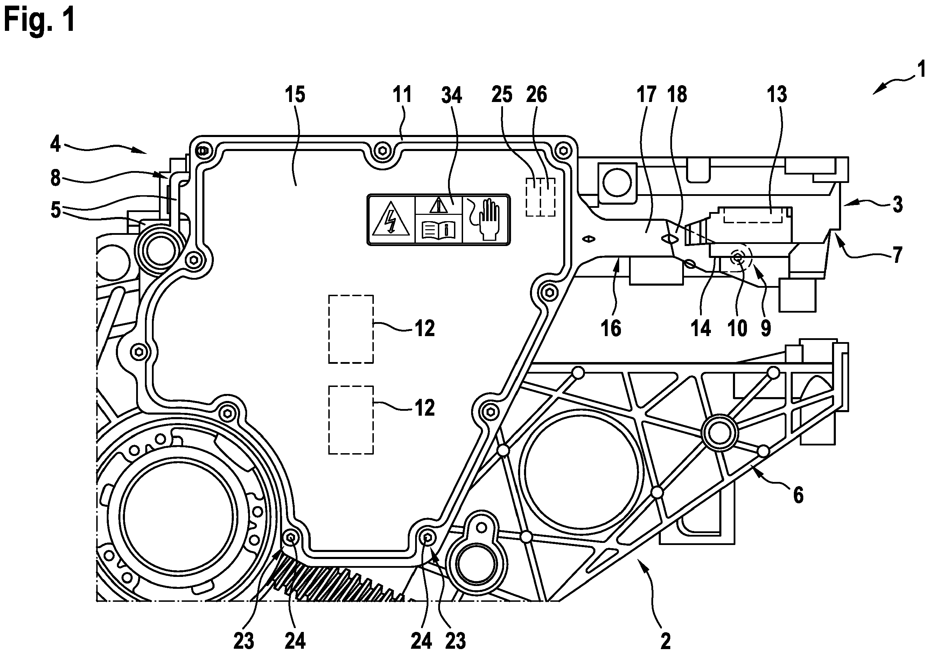

Fig. 1 ist eine Draufsicht auf ein erstes Ausführungsbeispiel einer Antriebseinrichtung 1. Diese umfasst eine elektrische Maschine 2, einen Stromrichter 3 und eine Verbindungsvorrichtung 4, welche die elektrische Verbindung der elektrischen Maschine 2 und des Stromrichters 3 realisiert.

Die elektrische Maschine 1 weist einen Gehäusekörper 5 auf, welcher in einen ersten Gehäuseabschnitt 6 für die elektrische Maschine 2, in einen zweiten Gehäuseabschnitt 7 für den Stromrichter und in einen dritten Gehäuseabschnitt 8 für die Verbindungsvorrichtung 4 untergliedert ist. Im zweiten Gehäuseabschnitt 7 umfasst der Gehäusekörper 5 ein erstes Befestigungsmittel 9 in Form eines Lochs mit einem Innengewinde. Ein zweites Befestigungsmittel 10 in Form einer Schraube ist vorgesehen, um eine Abdeckung 11 der Antriebseinrichtung 1 in Wechselwirkung mit dem ersten Befestigungsmittel 9 am Gehäusekörper 5 zu befestigen. Im vorliegenden Ausführungsbeispiel deckt die Abdeckung 11 den dritten Gehäuseabschnitt 8 ab, in welchem rein schematisch dargestellte spannungsführende Komponenten 12 angeordnet sind. Fig. 1 zeigt die Abdeckung 11 in einer ersten Stellung, in der sie den dritten Gehäuseabschnitt 8 verschließt und mittels der Befestigungsmittel 9, 10 am Gehäusekörper 5, hier konkret am zweiten Gehäuseabschnitt 7, befestigt ist.

Die Antriebseinrichtung 1 umfasst ferner ein erstes Verbindungsmittel 13, an das ein zweites Verbindungsmittel 14 zur Herstellung einer elektrisch leitfähigen Verbindung und einer Datenverbindung anschließbar ist. Das erste Verbindungsmittel 13 ist ein als Buchse ausgebildeter Steckverbinder, welcher durch eine Öffnung im zweiten Gehäuseabschnitt 7 durchgeführt ist. Das zweite Verbindungsmittel 14 ist dementsprechend ein als Stecker ausgebildeter Steckverbinder.

Ersichtlich sind das erste Befestigungsmittel 9 und das erste Verbindungsmittel 13 so angeordnet, dass in der ersten Stellung ein Zugriff auf das zweite Verbindungsmittel 10 in seiner die Abdeckung 11 befestigenden Position erst nach einem Lösen des zweiten Verbindungsmittels 14 vom ersten Verbindungsmittel 13 möglich ist. Dies wird dadurch realisiert, dass das zweite Verbindungsmittel 14 das erste und das zweite Befestigungsmittel 9, 10 im angeschlossenen Zustand überdeckt.

Die Abdeckung 11 umfasst einen Abdeckungsabschnitt 15 zum Abdecken eines Volumens des Gehäusekörpers 4 bzw. des dritten Gehäuseabschnitts 8, in welchem die Komponenten 12 aufgenommen sind, und einen vom Abdeckungsabschnitt 15 winklig abstehenden Befestigungsabschnitt 16, auf den das erste und zweite Befestigungsmittel 9, 10 zum Befestigen der Abdeckung 11 wirken. Der Befestigungsabschnitt 16 weist einen ersten Teilabschnitt 17 auf, der sich winklig vom Abdeckungsabschnitt 15 in die Zeichenebene von Fig. 1 hinein erstreckt und einen zweiten Teilabschnitt 18, der sich wiederum parallel zum Abdeckungsabschnitt 15 erstreckt und auf dem zweiten Gehäuseabschnitt 7 des Gehäusekörpers 5 aufliegt. Im zweiten Teilabschnitt 18 ist eine Durchgangsöffnung ausgebildet, welche das zweite Befestigungsmittel 10 zum Befestigen der Abdeckung 11 durchdringt.

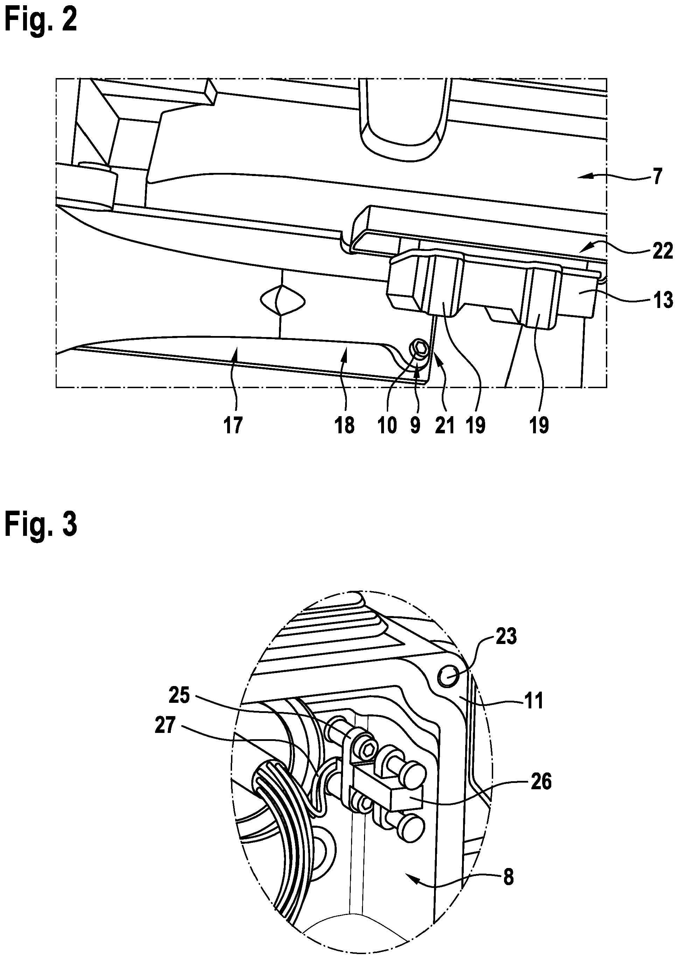

Fig. 2 ist eine Detailansicht der Antriebseinrichtung 1 im Bereich des ersten Verbindungsmittels wobei das zweite Verbindungsmittel 14 nicht dargestellt ist.

Das erste Verbindungsmittel 13 weist eine Führung 19 für das zweite Verbindungsmittel 14 auf, deren gedachte Verlängerung das erste Befestigungsmittel 9 überdeckt, sodass das zweite Befestigungsmittel 14 (siehe Fig. 1) im angeschlossenen Zustand die Befestigungsmittel 9, 10 überdeckt. Dazu ist das erste Befestigungsmittel 9 in einem Abschnitt 21 des Gehäusekörpers 5 bzw. des zweiten Gehäuseabschnitt 7 ausgebildet, der rechtwinklig zu einem weiteren Abschnitt 22 des Gehäusekörpers 5 bzw. des zweiten Gehäuseabschnitts 7, an dem das erste Verbindungsmittel 13 angeordnet ist, verläuft.

Wieder mit Bezug zu Fig. 1 umfasst die Antriebseinrichtung 1 mehrere dritte Befestigungsmittel 23 in Form von Löchern mit einem Innengewinde und eine entsprechende Anzahl von zweiten Befestigungsmittel 24 jeweils in Form einer Schraube. Von den dritten und vierten Befestigungsmitteln 23, 24 sind in Fig. 1 aus Gründen der Übersichtlichkeit jeweils nur zwei Stück mit Bezugszeichen versehen. Mittels der dritten und vierten Befestigungsmittel 23, 24 ist der Abdeckungsabschnitt 15 der Abdeckung 11 am dritten Gehäuseabschnitt 8 befestigbar. Ein Zugriff auf die vierten Befestigungsmittel 24 ist ersichtlich unabhängig vom Verbindungzustand des ersten und zweiten Verbindungsmittels 13, 14 möglich.

Fig. 3 ist eine weitere Detailansicht der Antriebseinrichtung 1, welche einen Ausschnitt des von der Abdeckung 11 abgedeckten Volumens des dritten Gehäuseabschnitts 8 ohne die Abdeckung 11 zeigt.

Innerhalb dieses Volumens ist ein drittes Verbindungsmittel 25 angeordnet, das am Gehäusekörper 5 befestigt ist. An der Abdeckung 11 ist ein viertes Verbindungsmittel 26 befestigt, das in der *ersten* Stellung der Abdeckung 11 mit dem dritten Verbindungsmittel 25 verbunden ist. In dieser Stellung stellt das vierte Verbindungsmittel 26 eine elektrisch leitfähige Verbindung einer Leiterschleife 27 her.

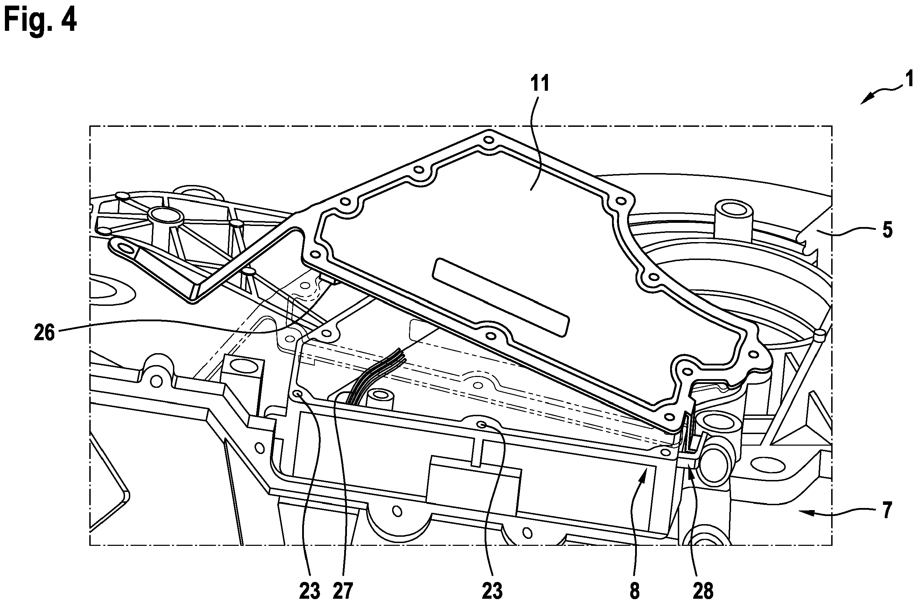

Fig. 4 ist eine perspektivische Ansicht der Antriebseinrichtung 1 beim Überführen der Abdeckung 11 aus der ersten Stellung in eine zweite Stellung.

Für das Überführen sind zunächst das zweite Verbindungsmittel 14 vom ersten Verbindungsmittel 13 sowie die vierten Befestigungsmittel 24 von den dritten Befestigungsmitteln 23 zu lösen. Da das zweite Verbindungsmittel 14 vom ersten Verbindungsmittel 13 gelöst ist, ist erst jetzt ein Zugriff auf das zweite Befestigungsmittel 10 möglich, um dieses vom ersten Befestigungsmittel 9 zu lösen. Dadurch kann die Abdeckung 11 aus der ersten Stellung in die zweite Stellung, in der ein Zugriff auf die Komponenten 12 möglich ist, überführt werden. Ersichtlich werden dabei auch das dritte Verbindungmittel 25 und das vierte Verbindungsmittel 26 voneinander getrennt, wodurch die Leiterschleife 27 unterbrochen wird. Im vorliegenden Ausführungsbeispiel bilden der dritte Gehäuseabschnitt 8 und die Abdeckung 11 ein Scharnier 28 aus, welches es ermöglicht die Abdeckung 11 durch schwenken aus der ersten Stellung in die zweite Stellung zu bewegen.

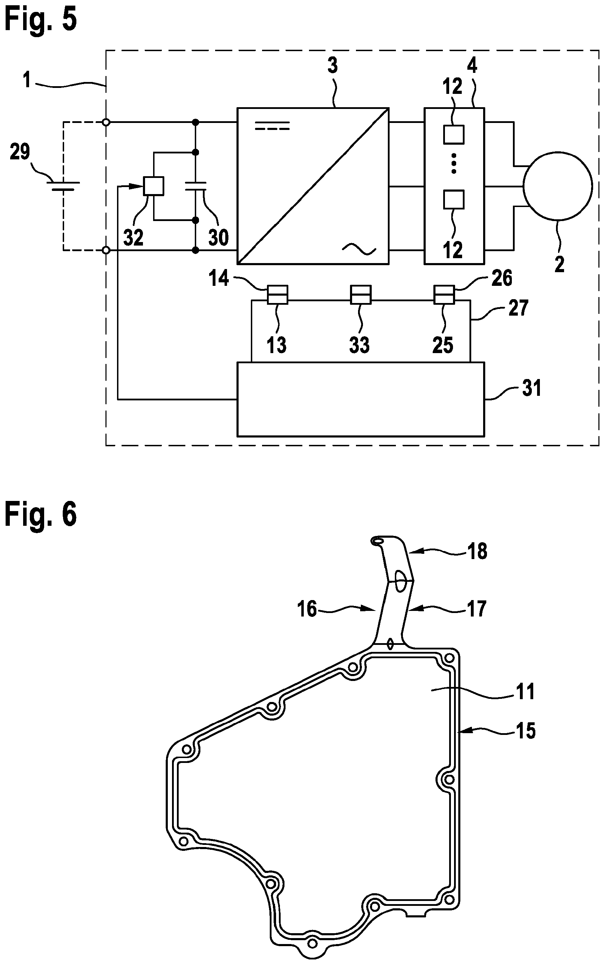

Fig. 5 ist ein Blockschaltbild der Antriebseinrichtung 1.

Im vorliegenden Ausführungsbeispiel ist der Stromrichter 3 als Wechselrichter ausgebildet, der eine von einer Hochvoltbatterie 29 bereitgestellte Gleichspannung in eine dreiphasige Wechselspannung für die elektrische Maschine 2 wandelt. Ersichtlich stellt die Verbindungsvorrichtung 4 eine entsprechende elektrische Verbindung zwischen dem Stromrichter 3 und der elektrischen Maschine 2 her. Daneben umfasst der Stromrichter 3 einen als Zwischenkreiskondensator vorgesehenen Kondensator 30.

Die Antriebseinrichtung 1 weist ferner eine Sicherheitseinrichtung auf, welche die Leiterschleife 27, eine Auswerteeinheit 31 und eine aktive Entladeeinrichtung 32 umfasst. Ersichtlich verbindet die Leiterschleife 27 das erste Verbindungsmittel 13, das dritte Verbindungsmittel 25 und eine optionale weitere Erfassungseinheit 33. Die Leiterschleife 27 wird dabei jeweils beim Lösen des zweiten Verbindungsmittel 14 vom ersten Verbindungsmittel 13, beim Lösen des vierten Verbindungsmittel 26 vom dritten Verbindungsmittel 25 und mittels der Erfassungseinheit 33 beim Lösen des zweiten Befestigungsmittels 10 vom ersten Befestigungsmittel 9 unterbrochen.

Eine jeweilige Unterbrechung wird von der Auswerteeinheit 31 als kritischer Zustand erfasst. Die Auswerteeinheit 31 löst bei der Erfassung des kritischen Zustands eine Sicherheitsfunktion aus, welche das Entladen des Zwischenkreiskondensators 30 mittels der Entladeeinrichtung 32 umfasst.

Folglich wird beim Lösen des zweiten Verbindungsmittels 14 vom ersten Verbindungsmittel 13 das Entladen des Kondensators 30 ausgelöst. Da nun zunächst das zweite Verbindungsmittel 10 vom ersten Verbindungsmittel 9 zu lösen ist, welches erst durch das Entfernen des zweiten Verbindungsmittels 14 freigelegt wird, besteht genug Zeit für das Entladen des Kondensators 30. Wenn auch die vierten Befestigungsmittel 24 von den dritten Befestigungsmittel 23 gelöst sind und die Abdeckung 11 aus der ersten Stellung in die zweite Stellung überführt wird, wird die Leiterschleife 27 als redundante Sicherheitsmaßnahme wegen der Trennung des vierten Verbindungsmittel 26 vom dritten Verbindungsmittel 25 unterbrochen, was ebenfalls das Entladen auslösen würde, wenn das Entfernen des zweiten Verbindungsmittels 14 vom ersten Verbindungsmittel 13 nicht korrekt erfasst worden wäre. Um zu verhindern, dass bei einem erneuten Befestigen der Abdeckung 11 am Gehäusekörper 5 das zweite Befestigungsmittel und das erste Befestigungsmittel 9 nicht verwendet werden und so ein sofortiges Öffnen der Abdeckung 11 nach einem erneuten Lösen des zweiten Verbindungsmittels 14 vom ersten Verbindungsmittel 13 ermöglicht wird, kann die Effektivität der Sicherheitseinrichtung durch die zusätzliche Erfassungseinheit 33 weiter erhöht werden.

Ein auf der Abdeckung 11 aufgebrachter, von außen sichtbare Aufkleber 34 mit einem Warnhinweis ergänzt das zuvor beschriebene Sicherheitskonzept der Antriebseinrichtung 1.

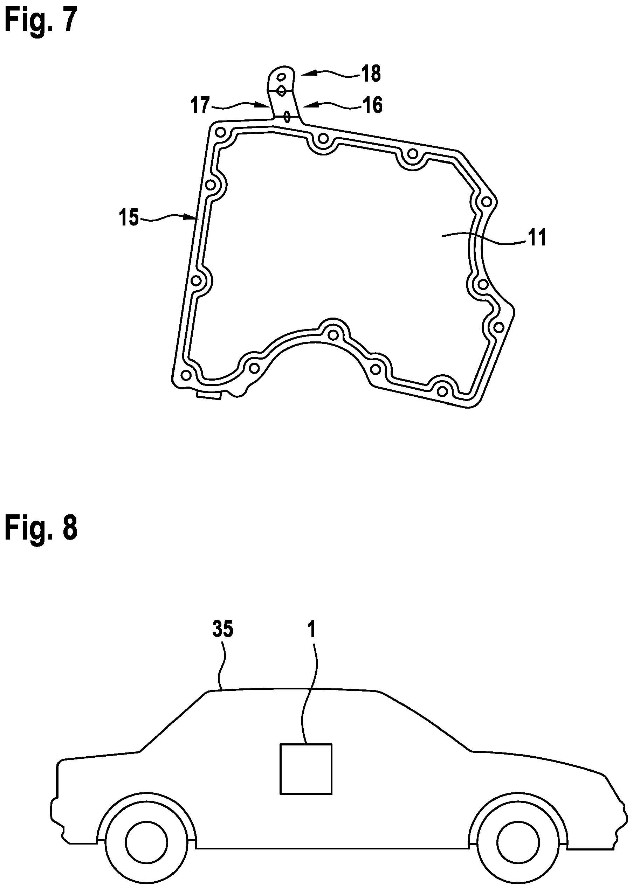

Fig. 6 und 7 sind jeweils perspektivische Ansichten einer Abdeckung 11 eines weiteren Ausführungsbeispiels der erfindungsgemäßen Antriebseinrichtung. Ersichtlich sind die Teilabschnitte 17, 18 bei der Abdeckung 11 gemäß Fig. 6 länger ausgebildet als bei der Abdeckung 11 gemäß Fig. 7. Die jeweiligen Befestigungsabschnitte 16 stehen dabei rechtwinklig vom Abdeckungsabschnitt 15 ab.

Fig. 8 ist eine Prinzipskizze eines Ausführungsbeispiels eines Fahrzeugs 35, welches eine Antriebseinrichtung 1 gemäß einem der zuvor beschriebenen Ausführungsbeispiel umfasst. Die Antriebseinrichtung 1 ist dazu eingerichtet, das Fahrzeug 35 anzutreiben, welches dementsprechend ein Elektrofahrzeug oder ein Hybridfahrzeug sein kann.

## Patentansprüche

1. Antriebseinrichtung (1) für ein elektrisch antreibbares Fahrzeug (35), umfassend
- einen Gehäusekörper (5) mit einem ersten Befestigungsmittel (9),
- eine Abdeckung (11), die nach Lösen eines mit dem ersten Befestigungsmittel (9) zum Befestigen der Abdeckung (11) am Gehäusekörper (5) wechselwirkenden zweiten Befestigungsmittels (10) aus einer ersten Stellung, in der die Abdeckung (11) im Betrieb der Antriebseinrichtung (1) spannungsführende Komponenten (12) der Antriebseinrichtung (1) abdeckt, in eine zweite Stellung, in welcher die Komponenten (12) freiliegen, bewegbar ist, und
- ein erstes Verbindungsmittel (13), an das ein zweites Verbindungsmittel (14) zur Herstellung einer elektrisch leitfähigen Verbindung und/oder einer Datenverbindung anschließbar ist,
**dadurch gekennzeichnet, dass**
das erste Befestigungsmittel (9) und das erste Verbindungsmittel (13) so angeordnet sind, dass in der ersten Stellung ein Zugriff auf das zweite Befestigungsmittel (10) in seiner die Abdeckung (11) befestigenden Position erst nach einem Lösen des zweiten Verbindungsmittels (14) vom ersten Verbindungsmittel (13) möglich ist.

2. Antriebseinrichtung nach Anspruch 1, wobei
das erste Verbindungsmittel (13) eine Führung (19) für das zweite Verbindungsmittel (14) aufweist, deren gedachte Verlängerung das erste Befestigungsmittel (9) überdeckt.

3. Antriebseinrichtung nach Anspruch 1 oder 2, wobei
das erste Befestigungsmittel (9) und das erste Verbindungsmittel (13) jeweils an einem Abschnitt (21, 22) des Gehäusekörpers angeordnet sind, wobei die Abschnitte (21, 22) winklig, insbesondere rechtwinklig, zueinander verlaufen.

4. Antriebseinrichtung nach einem der vorhergehenden Ansprüche, wobei
das erste Verbindungsmittel (13) ein, insbesondere als Buchse ausgebildeter, Steckverbinder ist und/oder
das zweite Verbindungsmittel (14) ein, insbesondere als Stecker ausgebildeter, Steckverbinder ist und/oder
das erste Befestigungsmittel (9) ein Loch mit einem Innengewinde ist und/oder das zweite Befestigungsmittel (10) eine Schraube ist.

5. Antriebseinrichtung nach einem der vorhergehenden Ansprüche, ferner umfassend
eine Sicherheitseinrichtung, welche zum Erfassen wenigstens eines kritischen Zustands der Antriebseinrichtung (1) und zum Auslösen einer Sicherheitsfunktion infolge der Erfassung des kritischen Zustands eingerichtet ist.

6. Antriebseinrichtung nach Anspruch 5, wobei
die Sicherheitseinrichtung dazu eingerichtet ist, den einen kritischen Zustand zu erfassen, wenn
- die Verbindungsmittel (13, 14) nicht miteinander gekoppelt sind und/oder
- sich die Abdeckung (11) nicht in der ersten Stellung befindet und/oder
- kein zweites Befestigungsmittel (10) mit dem ersten Befestigungsmittel (9) wechselwirkt.

7. Antriebseinrichtung nach einem der Ansprüche 5 oder 6, wobei
die Sicherheitsfunktion ein Entladen eines Kondensators (30) der Antriebseinrichtung (1) umfasst.

8. Antriebseinrichtung nach einem der vorhergehenden Ansprüche, wobei
die Abdeckung einen Abdeckungsabschnitt (15) zum Abdecken eines die Komponenten (12) aufnehmenden Volumens des Gehäusekörpers (5) und einen vom Abdeckungsabschnitt (15) abstehenden Befestigungsabschnitt (16) aufweist, auf welchen das erste und zweite Befestigungsmittel (9, 10) zum Befestigen der Abdeckung (11) wirken.

9. Antriebseinrichtung nach einem der vorhergehenden Ansprüche, wobei
der Gehäusekörper (5) und die Abdeckung (11) ein Scharnier (28) ausbilden, mittels dessen die Abdeckung (11) durch Schwenken aus der ersten Stellung in die zweite Stellung bewegbar ist.

10. Antriebseinrichtung nach einem der vorhergehenden Ansprüche, ferner umfassend
eine elektrische Maschine (2) und einen Stromrichter (3), wobei die von der Abdeckung (11) abdeckbaren Komponenten (12) elektrische Leitungen umfassen, welche die elektrische Maschine (2) und den Stromrichter (3) verbinden.

11. Fahrzeug (35), umfassend eine Antriebseinrichtung (1) nach einem der vorhergehenden Ansprüche.
